Europäisches Patentamt

European Patent Office

Office européen des brevets

(19)

(11) **EP 1 600 783 A1**

(12) **EUROPÄISCHE PATENTANMELDUNG**

(43) Veröffentlichungstag:
   **30.11.2005 Patentblatt 2005/48**

(51) Int Cl.[7]: **G01R 19/00**, G01R 19/257,
   G01R 15/14

(21) Anmeldenummer: **05011047.7**

(22) Anmeldetag: **21.05.2005**

(84) Benannte Vertragsstaaten:
   **AT BE BG CH CY CZ DE DK EE ES FI FR GB GR
   HU IE IS IT LI LT LU MC NL PL PT RO SE SI SK TR**
   Benannte Erstreckungsstaaten:
   **AL BA HR LV MK YU**

(30) Priorität: **27.05.2004 DE 102004026537
   27.07.2004 DE 102004036352**

(71) Anmelder: **ATMEL Germany GmbH
   74072 Heilbronn (DE)**

(72) Erfinder: **Hehn, Lars , Dipl.-Ing.
   74080 Heilbronn (DE)**

(54) **Schaltung zur Strommessung und Stromüberwachung**

(57)   Es ist eine Schaltkreis zur Strommessung und Stromüberwachung in einem Kraftfahrzeug vorgesehen, mit

- einem Messschaltkreis mit einem, mit einem Messwiderstand ($R_s$) verbundenen ersten Subtrahierschaltkreis (Op1),
- einem Offsetschaltkreis (Op2), der mit dem ersten Subtrahierschaltkreis derart verbunden ist, dass eine erste Ausgangsspannung des ersten Subtrahierschaltkreises um eine Offsetspannung erhöht ist,

- einem zweiten Subtrahierschaltkreis (Op3), der mit dem Offsetschaltkreis und dem ersten Subtrahierschaltkreis derart verbunden ist, dass eine zweite Ausgangsspannung des zweiten Subtrahierschaltkreises im wesentlichen unabhängig von der Offsetspannung ist, und
- einem Komparatorschaltkreis (Op4,Op5) mit mindestens einer Schaltschwelle ($U_{ref1}$,$U_{ref2}$), der mit dem zweiten Subtrahierschaltkreis zum Vergleich der zweiten Ausgangsspannung mit der zumindest einen Schaltschwelle verbunden ist.

FIG.1

EP 1 600 783 A1

**Beschreibung**

Die Erfindung betrifft eine Schaltung zur Strommessung und Stromüberwachung und deren Verwendung für eine Funktionseinheit eines Kraftfahrzeugs.

Es ist bekannt einen Operationsverstärker als Subtrahierschaltung zu beschalten, so dass ein erstes Eingangspotential eines negativen Eingangs der Subtrahierschaltung von einem zweiten Eingangspotential eines positiven Eingangs der Subtrahierschaltung subtrahiert wird. Zudem ist die Einstellung einer Offsetspannung möglich, indem ein Anschluss der Subtrahierschaltung auf ein bestimmtes Potential gelegt wird. Die Offsetspannung bewirkt, dass die Ausgangsspannung der Subtrahierschaltung die Summe aus der Offsetspannung und der Differenzspannung zwischen dem ersten und dem zweiten Eingangspotential ist. Zur Strommessung ist der erste Eingang und der zweite Eingang jeweils mit zumindest einem Anschluss eines Messwiderstands verbunden.

Aus der DE 37 00 987 C2 ist eine Einrichtung zur Erfassung einer elektrischen Spannung zur Verarbeitung in einem Mikrorechner bekannt. Die Einrichtung ist mit wenigstens einem Analog/Digital-Wandler, der eine Wandlungsbreite von n Bit aufweist, ausgestattet. Die Einrichtung ist mit einem Digital/Analog-Wandler und mit einem Differenzverstärker, welcher die Differenz zwischen der zu messenden Spannung und dem Ausgangssignal des Digital/Analog-Wandlers verstärkt und dem wenigstens einen Analog/Digital-Wandler des Mikrorechners zuführt, ausgestattet.

Der Mikrorechner umfasst Mittel, die die Umwandlung der zu messenden Spannung mittels des oder eines der Analog/Digital-Wandler in ein erstes digitales Wort steuern, und die die höchstwertigen Bits dieses Wortes über den Digital/Analog-Wandler an den Differenzverstärker abgeben. Zudem steuern die Mittel die Umwandlung der verstärkten Differenz zwischen der zu messenden Spannung und dem Ausgangssignal des Digital/Analog-Wandlers mittels des oder eines der Analog/Digital-Wandler in ein zweites digitales Wort. Zudem bilden die Mittel aus dem ersten und zweiten digitalen Wort ein m + n Bit breites, die zu messende Spannung repräsentierendes digitales Ergebnis, so dass die Auflösung der gemessenen Spannung m + n Bit beträgt, wobei m < n ist. Die Verstärkung des Differenzverstärkers beträgt $k = 2^m$. Der Digital/Analog-Wandler weist eine Wortbreite von m + 1 Bit auf. Der Mikrorechner umfasst Mittel, die beim Übergang von einem durch die höchstwertigen Bits der gewandelten Spannung bezeichneten Untermessbereich zu einem anderen eine Hysterese bilden.

Ausgehend insbesondere von der DE 37 00 987 C2 als Stand der Technik liegt der Erfindung liegt die Aufgabe zu Grunde eine Schaltung anzugeben, die die Erfassung von elektrischen Größen weiterentwickelt und sowohl zur Strommessung als auch zur Stromüberwachung geeignet ist.

Die Aufgabe wird durch die Merkmale der unabhängigen Ansprüche gelöst. Vorteilhafte Weiterbildungen der Erfindung sind in den Unteransprüchen angegeben.

Demnach weist die erfindungsgemäße Schaltung zur Strommessung und Stromüberwachung mehrere Unterschaltkreise auf. Der erste Unterschaltkreis ist ein Messschaltkreis mit einem ersten Subtrahierschaltkreis, der mit einem Messwiderstand verbundenen ist. Der zweite Unterschaltkreis ist ein Offsetschaltkreis, der mit dem ersten Subtrahierschaltkreis derart verbunden ist, dass eine erste Ausgangsspannung des ersten Subtrahierschaltkreises um eine Offsetspannung erhöht ist. Diese Ausgangsspannung des ersten Subtrahierschaltkreises ist mittels der Offsetspannung einstellbar, um vorzugsweise einen mit dem Ausgang des ersten Subtrahierschaltkreises verbundenen Auswerteschaltkreis in einem optimalen Arbeitspunkt bezüglich dessen Eingangssignalbereichs zu betreiben. Weist der Auswerteschaltkreis beispielsweise einen Analog-Digital-Umsetzer auf, kann dieser nur mit Eingangsspannungen betrieben werden, die in digitale Information umsetzbar sind.

Der dritte Unterschaltkreis ist ein zweiter Subtrahierschaltkreis, der mit dem Offsetschaltkreis und dem ersten Subtrahierschaltkreis derart verbunden ist, dass eine zweite Ausgangsspannung des zweiten Subtrahierschaltkreises im wesentlichen unabhängig von der Offsetspannung ist. Der vierte Unterschaltkreis ist ein Komparatorschaltkreis mit mindestens einer Schaltschwelle, der mit dem zweiten Subtrahierschaltkreis zum Vergleich der zweiten Ausgangsspannung mit der zumindest einen Schaltschwelle verbunden ist. Der Komparatorschaltkreis ermöglicht eine schnelle Auswertung unabhängig von der Ausbildung des mit dem ersten Subtrahierschaltkreises verbundenen Auswerteschaltkreises. Hierdurch kann die Überwachung und Messung des Stromes durch die getrennte Auswertung durch den Komparatorschaltkreis beziehungsweise durch den Auswerteschaltkreis separat erfolgen. Die Überwachung durch den Komparatorschaltkreis erfolgt dabei unabhängig von der Offsetspannung.

Dies ist besonders bezüglich einer Weiterbildung der Erfindung vorteilhaft, in der der Offsetschaltkreis derart ausgebildet ist, dass die Offsetspannung einstellbar ist. In diesem Fall ist die Einstellung der Offsetspannung zur Optimierung der Eingangsspannung des Auswerteschaltkreis unabhängig von der Überwachung des Stromes mittels des Komparatorschaltkreises. Dies ist insbesondere dann vorteilhaft, wenn der Strom auch während einer beispielsweise fortlaufenden Veränderung der Offsetspannung zu jedem Zeitpunkt vorzugsweise kontinuierlich überwacht werden soll.

Neben einer möglichen kontinuierlichen Einstellung der Offsetspannung ist in einer vorteilhaften Ausgestaltung der Erfindung vorgesehen, dass der Offsetschaltkreis zur Einstellung der Offsetspannung einen Spannungsteiler, insbesondere mit schaltbaren Widerständen aufweist. Unter schaltbaren Widerständen werden mehrere mit jeweils einem in Reihe oder parallel geschaltenen Schalter, vorzugsweise ein MOSFET-Transistor verstanden. Mittels der Schalter ist aus den mehreren Einzelwiderständen jeweils ein Gesamtwiderstand einstellbar. So kann beispielsweise ein Widerstand des Spannungsteilers aus mehreren Einzelwiderständen bestehen, die zueinander parallel geschalten sind und durch jeweils einen Transistor aktiviert werden.

Eine besonders vorteilhafte Weiterbildung sieht vor, dass der Messschaltkreis zur bi-direktionalen Strommessung ausgebildet ist. Demzufolge können beide Stromrichtungen, die durch den Messwiderstand fließen sowohl gemessen, als auch überwacht werden. Eine weitere Schaltschwelle des Komparatorschaltkreises ermöglicht es negative Ausgangsspannungen des ersten Subtrahierschaltkreises zu überwachen.

Vorzugsweise ist der Messschaltkreis derart ausgebildet ist, dass eine Verstärkung des ersten Subtrahierschaltkreises einstellbar ist. Eine Einstellbarkeit wird vorzugsweise durch eine Rechen- und Steuereinheit gesteuert, die je nach erwartetem oder vorgegebenen Messbereich die Empfindlichkeit des Messschaltkreises durch die Einstellung der Verstärkung anpasst.

Weiterbildend ist dabei vorgesehen, dass zur Einstellung der Verstärkung Widerstände des ersten Subtrahierschaltkreises schaltbar sind. Auch in diesem Fall werden vorzugsweise mehrere Widerstände mit jeweils einem Reihenschalttransistor parallel geschalten. Alternativ können auch Widerstände mit jeweils einem parallelen Schalttransistor in Reihe geschalten sein.

Um eine Überwachung des Messstromes innerhalb eines gewünschten Sollbereiches zu ermöglichen, weist der Komparatorschaltkreis vorzugsweise einen Fensterdiskriminator auf.

Eine weitere vorteilhafte Ausgestaltung der Erfindung sieht vor, dass der Messschaltkreis, der Offsetschaltkreis, der zweite Subtrahierschaltkreises und der Komparatorschaltkreis auf einem einzigen Halbleiterchip integriert sind. Diese können zusammen mit einer Recheneinheit, insbesondere einem Mikrocontroller als sogenannte intelligente Leistungselektronik ausgebildet sein.

Eine bevorzugte Verwendung des Schaltkreises zur Strommessung und Stromüberwachung eines Laststromes einer Last ist in einer Funktionseinheit eines Kraftfahrzeugs vorgesehen. Die Verwendung für eine Kraftfahrzeugelektronik weist die Besonderheit auf, dass die Überwachung des Stromes selbst in dem Fall noch voll funktionsfähig ist, wenn die Strommessung aufgrund eines elektrischen Defektes oder eines Programmfehlers in einer Auswertesoftware nicht mehr möglich ist. Dennoch führt ein Überstrom aufgrund der von der Messung unabhängig funktionierenden Überwachung des Stromes nicht zu einem Totalausfall der Elektronik, da der zerstörende Leistungsstrom vorher abgeschaltet werden kann.

Im Folgenden wird die Erfindung anhand von einem zeichnerisch dargestellten Ausführungsbeispiel näher erläutert.

Dabei zeigen

Figur 1     einen Schaltplanausschnitt mit einer Schaltung zur Strommessung und Stromüberwachung,

Figur 2a     einen Schaltplanausschnitt eines ersten schaltbaren Widerstandsnetzwerkes, und

Figur 2b     einen Schaltplanausschnitt eines zweiten schaltbaren Widerstandsnetzwerkes.

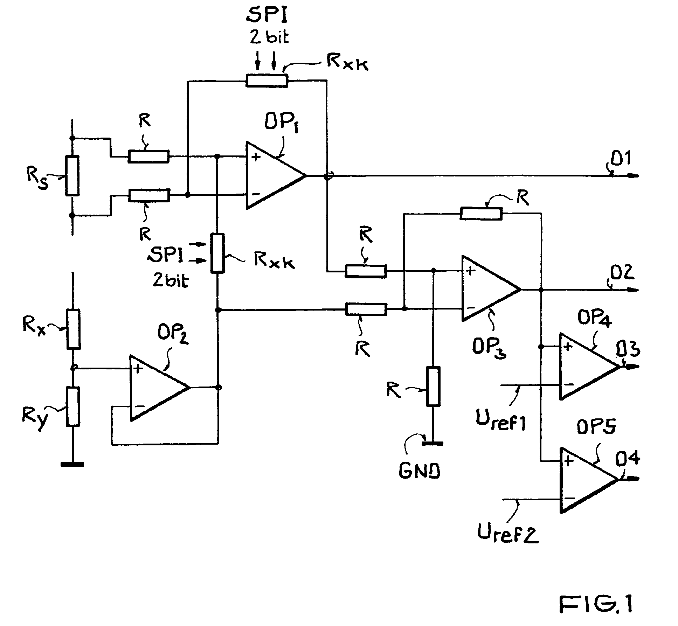

Der in Figur 1 dargestellte Schaltplanausschnitt kann prinzipiell in jeden Gesamtschaltplan integriert sein. Vorzugsweise ist dabei vorgesehen, dass die in Figur 1 dargestellten Schaltplanelemente mit einer Recheneinheit, beispielsweise einem in Figur 1 nicht dargestellten Mikrocontroller auf einem Halbleiterchip integriert sind. Die hierzu verwendete Technologie wird beispielsweise als intelligente Leistungselektronik (smart power) bezeichnet.

Figur 1 zeigt einen Messwiderstand $R_s$, der auch als Shunt-Widerstand bezeichnet wird. Dieser Messwiderstand $R_s$ ist ausgebildet zur Messung von Strömen, wie sie üblicherweise zum Betrieb von Funktionseinheiten von Kraftfahrzeugen oder Teilen davon benötigt werden. Die Ströme können dabei bei Spannungen des Bordnetzes, beispielsweise den bisherigen 12V Bordnetzen, besonders bevorzugt jedoch bei 42V Bordnetzen gemessen und überwacht werden. Ein erster Differenzverstärker $Op_1$ des Schaltungsausschnitts der Figur 1 ist hierzu mit mehreren Widerständen R und R x k als erster Subtrahierschaltkreis beschaltet, der den aufgrund des Stromflusses durch den Messwiderstand $R_s$ entstehenden Potentialunterschied zwischen den Anschlüssen des Messwiderstandes $R_s$ als Ausgangsspannung an den Ausgang $O_1$ abgibt. Die Ausgangsspannung am Ausgang 01 ist mit einem Analog-Digital-Umsetzer und mit einer an dem Analog-Digital-Umsetzer angeschlossenen Recheneinheit verbunden (in Figur 1 nicht dargestellt), um die fortlaufend ermittelten Messwerte des Messstromes auszuwerten.

Mittels einer Änderung der Widerstände R x k ist die Einstellung einer Spannungsverstärkung durch den $Op_1$ möglich. Die Änderung der Widerstände ist beispielsweise durch eine serielle 2-bit Schnittstelle SPI möglich. Hierzu wird die zugehörige Information in ein, in Figur 1 nicht dargestelltes Register geladen, wobei die Ausgänge des Registers Einzelschalttransistoren ansteuern. Mögliche alternative Ausgestaltungsformen der Widerstände R x k sind in den Figuren 2a und 2b als Widerstandsnetzwerke dargestellt. Jedes Netzwerk umfasst dabei mehrere Widerstände $R_1$, $R_2$, $R_3$, $R_4$ bis $R_k$, denen jeweils ein Schalterelement $S_1$, $S_2$, $S_3$, $S_4$ bis $S_k$ zugeordnet ist. Diese Schaltelemente

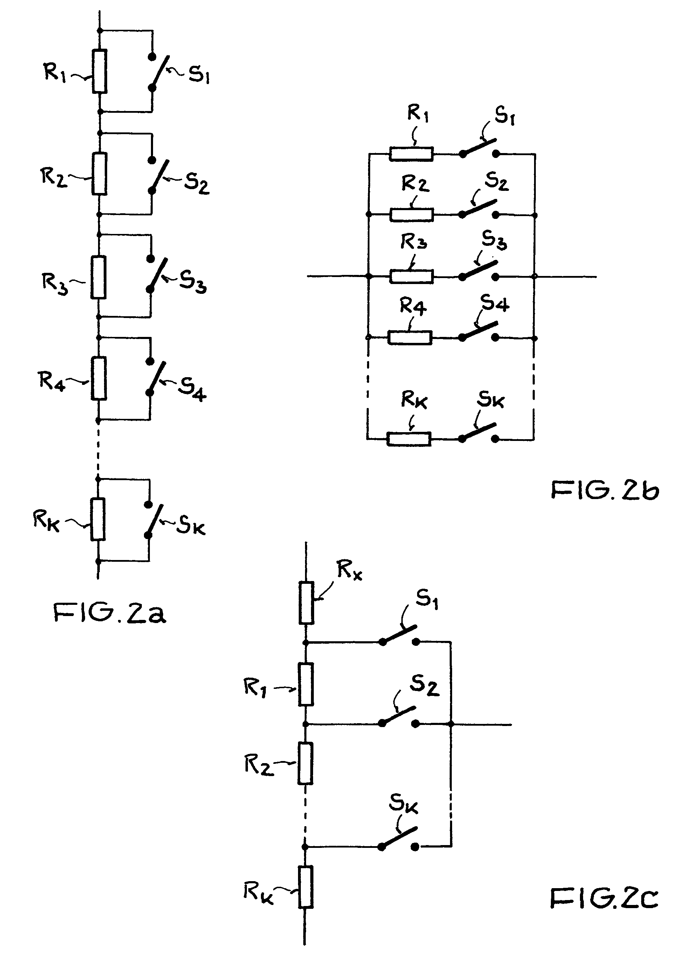

$S_1$, $S_2$, $S_3$, $S_4$ bis $S_k$ sind vorzugsweise die zuvor erwähnten Schalttransistoren, beispielsweise MOSFET-Transistoren. In Figur 2a ist eine Reihenschaltung der Widerstände $R_1$, $R_2$, $R_3$, $R_4$ bis $R_k$, während in Figur 2b eine Parallelschaltung der Widerstände $R_1$, $R_2$, $R_3$, $R_4$ bis $R_k$ dargestellt ist. Eine weitere Möglichkeit zur Realisierung des Spannungsteilers aus den Widerständen $R_x$ und $R_y$ ist in Figur 2c dargestellt. In Figur 2c bilden die Widerstände $R_1$ bis $R_k$ mit dem Widerstand $R_x$ einen Spannungsteiler, wobei unterschiedliche Spannungswerte des Spannungsteilers mittels der Schalterelemente $S_1$ bis $S_k$ ausgewählt werden können. Bilden die Widerstände $R_1$ bis $R_k$ den Widerstand $R_y$ der Figur 1, so können auf den positiven Eingang des Operationsverstärkers $Op_2$ unterschiedlich Spannungen geschalten werden. Auch in diesem Fall ist eine Auswahl eines oder mehrerer Schaltelemente $S_1$ bis $S_k$ über eine serielle 2-bit SPI-Schnittstelle möglich (in Figur 2c nicht dargestellt).

Der Schaltungsausschnitt der Figur 1 zeigt neben dem ersten Subtrahierer einen Offsetschaltkreis, der aus einem zweiten Differenzverstärker $Op_2$ und den Widerständen $R_x$ und $R_y$ besteht. Der zweiter Differenzverstärker $Op_2$ stellt somit niederohmig an seinem Ausgang eine Offsetspannung bereit, wobei der Ausgang des zweiten Differenzverstärkers $Op_2$ mit einem Widerstand R x k des ersten Subtrahierschaltkreises verbunden ist. Die Ausgangsspannung des ersten Subtrahierschaltkreises ist

$$U_{O1} = I_M * R_s * k + U_{offset}$$

Die Offsetzspannung ist durch die beiden, als Spannungsteiler zwischen der Versorgungsspannung VCC und Masse geschalteten Widerständen $R_x$ und $R_y$ einstellbar. Die Offsetspannung $U_{offset}$ berechnet in diesem Ausführungsbeispiel durch

$$U_{offset} = VCC * R_y/(R_x+R_y)$$

Demzufolge muss lediglich dieser erste Differenzverstärker $Op_1$ für einen großen Gleichspannungsbereich (common mode Bereich) ausgelegt sein, während die nachfolgenden Stufen lediglich für kleinere positive Spannungen ausgelegt werden müssen. Die Einstellung zumindest eines der Widerstände $R_x$ und $R_y$ erfolgt dabei vorteilhafterweise mittels der bereits zu den Figuren 2a und 2b beschriebenen schaltbaren Widerstandsnetzwerke.

Weiterhin ist in der Figur 1 ein zweiter Subtrahierschaltkreis vorgesehen, der den Differenzverstärker $Op_3$ und mehrere Widerstände R aufweist. Der zweite Subtrahierschaltkreis ist mit seinem positiven Eingang mit dem Ausgang des ersten Subtrahierschaltkreises verbunden, während der negative Eingang des zweiten Subtrahierschaltkreises mit dem Ausgang des Offsetschaltkreises verbunden ist. Dieser Offsetschaltkreis ermöglich dabei sowohl eine chip-interne als auch eine chip-externe Einstellung der Offsetspannung. Mittels der Offsetspannung ist es möglich, Ströme unabhängig von der Richtung des Stromflusses durch den Messwiderstand $R_s$ zu messen und zu überwachen.

Die Verbindung des Offsetschaltkreises bewirkt, dass die Ausgangsspannung des zweiten Subtrahierers aus der Augangsspannung des ersten Subtrahierers weniger der in der Augangsspannung des ersten Subtrahierers enthaltenen Offsetspannung gebildet ist. Demzufolge ist

$$U_{O2} = I_M * R_s * k$$

Die Ausgangsspannung des zweiten Subtrahiererschaltkreises ist damit unabhängig von der Einstellung der Offsetspannung und zu der am Messwiderstand $R_s$ gemessenen Messspannung proportional. Der Ausgang des zweiten Subtrahierschaltkreises ist mit dem Ausgang $O_2$ verbunden, der weitere Verbindungen zu anderen analogen Schaltkreisen, beispielsweise zu einem Regelschaltkreis zur Regelung eines Sollstromes, ermöglicht.

Der vierte Differenzverstärker $Op_4$ und der fünfte Differenzverstärker $Op_5$ dienen als Komparatoren, die eine erste und eine zweite jeweils Masse-bezogene Referenzspannung $U_{ref1}$ beziehungsweise $U_{ref2}$ mit der Ausgangsspannung des zweiten Subtrahierschaltkreises vergleichen. Der Ausgang des vierten Differenzverstärkers $Op_4$ ist dabei mit dem Ausgang $O_3$, der fünfte Differenzverstärker $Op_5$ mit dem Ausgang $O_4$ verbunden. Die Ausgangsspannungen des vierten beziehungsweise fünften Differenzverstärkers $Op_4$, $Op_5$ werden als digitale Ausgangssignale zur schnellen Steuerung der Funktionseinheit des Kraftfahrzeugs genutzt, indem diese beispielsweise mit in Figur 1 nicht dargestellten Schaltleistungstransistoren verbunden sind, die ein Abschalten eines Kurzschlussstromes ermöglichen. Selbstverständlich ist der in Figur 1 dargestellte Schaltplanausschnitt auch mehrmals beispielsweise parallel anzuordnen, um mehrere unterschiedliche Ströme zu messen und zu überwachen.

**Bezugzeichenliste**

| | |
|---|---|
| $R_s$, R, $R_x$, $R_y$, R x k,<br>$R_1$, $R_2$, $R_3$, $R_4$, $R_k$ | Widerstand, Widerstandsnetzwerk |
| $Op_1$, $Op_2$, $Op_3$, $Op_4$, $Op_5$ | Differenzverstärker, Operationsverstärker |
| GND | Masse |
| VCC | Versorgungsspannung (positiv) |
| $O_1$, $O_2$, $O_3$, $O_4$ | Ausgang |
| $U_{ref1}$, $U_{ref2}$ | Referenzspannung |
| $S_1$, $S_2$, $S_3$, $S_4$, $S_k$ | Schalter, Schalttransistoren, MOSFET-Transistoren |

**Patentansprüche**

1. Schaltkreis zur Strommessung und Stromüberwachung, mit

   - einem Messschaltkreis mit einem, mit einem Messwiderstand ($R_s$) verbundenen ersten Subtrahierschaltkreis ($Op_1$),
   - einem Offsetschaltkreis ($Op_2$), der mit dem ersten Subtrahierschaltkreis ($Op_1$) derart verbunden ist, dass eine erste Ausgangsspannung des ersten Subtrahierschaltkreises ($Op_1$) um eine Offsetspannung erhöht ist,
   - einem zweiten Subtrahierschaltkreis ($Op_3$), der mit dem Offsetschaltkreis ($Op_2$) und dem ersten Subtrahierschaltkreis ($Op_1$) derart verbunden ist, dass eine zweite Ausgangsspannung des zweiten Subtrahierschaltkreises ($Op_3$) im wesentlichen unabhängig von der Offsetspannung ist, und
   - einem Komparatorschaltkreis ($Op_4$, $Op_5$) mit mindestens einer Schaltschwelle, der mit dem zweiten Subtrahierschaltkreis ($Op_3$) zum Vergleich der zweiten Ausgangsspannung mit der zumindest einen Schaltschwelle verbunden ist.

2. Schaltkreis nach Anspruch 1,
   wobei
   der Offsetschaltkreis derart ausgebildet ist, dass die Offsetspannung einstellbar ist.

3. Schaltkreis nach Anspruch 2,
   wobei
   der Offsetschaltkreis zur Einstellung der Offsetspannung einen Spannungsteiler, insbesondere mit schaltbaren Widerständen aufweist.

4. Schaltkreis nach einem der vorhergehenden Ansprüche,
   wobei
   der Messschaltkreis zur bi-direktionalen Strommessung ausgebildet ist.

5. Schaltkreis nach einem der vorhergehenden Ansprüche,
   wobei
   der Messschaltkreis derart ausgebildet ist, dass eine Verstärkung des ersten Subtrahierschaltkreises einstellbar ist.

6. Schaltkreis nach Anspruch 5,
   wobei
   zur Einstellung der Verstärkung Widerstände des ersten Subtrahierschaltkreises schaltbar sind.

7. Schaltkreis nach einem der vorhergehenden Ansprüche,
   wobei
   der Komparatorschaltkreis einen Fensterdiskriminator aufweist.

8. Schaltkreis nach einem der vorhergehenden Ansprüche,
   wobei
   der Messschaltkreis, der Offsetschaltkreis, der zweite Subtrahierschaltkreis und der Komparatorschaltkreis auf einem einzigen Halbleiterchip integriert sind.

9. Verwendung eines Schaltkreises nach einem der vorhergehenden Ansprüche zur Strommessung und Stromüberwachung eines Laststromes einer Last einer Funktionseinheit eines Kraftfahrzeugs.

FIG.1

FIG.2a

FIG.2b

FIG.2c

**Europäisches Patentamt**

# EUROPÄISCHER RECHERCHENBERICHT

Nummer der Anmeldung

EP 05 01 1047

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 2002/180418 A1 (JONES DAVID M ET AL) 5. Dezember 2002 (2002-12-05) * Zusammenfassung; Abbildung 1 * * Absatz [0022] - Absatz [0036] * * Absatz [0001] * ----- | 1-9 | G01R19/00 G01R19/257 G01R15/14 |
| A,D | DE 37 00 987 C2 (ROBERT BOSCH GMBH; ROBERT BOSCH GMBH, 70469 STUTTGART, DE) 28. Juli 1988 (1988-07-28) * Abbildungen 1,2 * ----- | 1-9 | |
| A | US 6 335 611 B1 (SASAKI MANABU) 1. Januar 2002 (2002-01-01) * Zusammenfassung; Abbildungen 1-7,15 * ----- | 1-9 | |
| A | US 5 920 189 A (FISHER ET AL) 6. Juli 1999 (1999-07-06) * Zusammenfassung; Abbildung 1 * ----- | 1-9 | |

RECHERCHIERTE SACHGEBIETE (Int.Cl.7)

G01R

Der vorliegende Recherchenbericht wurde für alle Patentansprüche erstellt

| Recherchenort | Abschlußdatum der Recherche | Prüfer |
|---|---|---|
| Berlin | 8. September 2005 | Ernst, M |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
..................................................................................
& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 05 01 1047

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-09-2005

| Im Recherchenbericht angeführtes Patentdokument | Datum der Veröffentlichung | Mitglied(er) der Patentfamilie | Datum der Veröffentlichung |
|---|---|---|---|
| US 2002180418 A1 | 05-12-2002 | KEINE | |
| DE 3700987 C2 | 28-07-1988 | DE 3700987 A1<br>WO 8805619 A1 | 28-07-1988<br>28-07-1988 |
| US 6335611 B1 | 01-01-2002 | JP 2001043904 A<br>TW 483213 B | 16-02-2001<br>11-04-2002 |
| US 5920189 A | 06-07-1999 | KEINE | |